Europäisches Patentamt

(19) European Patent Office

Office européen des brevets

(11) Publication number: **0 026 050**
**B1**

(12) **EUROPEAN PATENT SPECIFICATION**

(45) Date of publication of patent specification: 26.01.83     (51) Int. Cl.³: **H 04 L 1/10**

(21) Application number: **80302957.8**

(22) Date of filing: **27.08.80**

(54) Improvements in or relating to interleavers and de-interleavers.

(30) Priority: **19.09.79 GB 7932467**

(43) Date of publication of application:
**01.04.81 Bulletin 81/13**

(45) Publication of the grant of the patent:
**26.01.83 Bulletin 83/4**

(84) Designated Contracting States:
**CH DE FR IT LI NL SE**

(56) References cited:
**DE - A - 2 240 057**
**FR - A - 2 408 251**
**GB - A - 1 223 863**

(73) Proprietor: **THE MARCONI COMPANY LIMITED**
**Marconi House New Street**
**Chelmsford Essex CM1 1PL (GB)**

(72) Inventor: **Haine, John Leslie**
**31, Sandford Road**
**Chelmsford Essex CM2 6DE (GB)**

(74) Representative: **Hoste, Colin Francis**
**The Marconi Company Limited Marconi House**
**New Street**
**Chelmsford, Essex CM1 1PL (GB)**

Courier Press, Leamington Spa, England.

## Improvements in or relating to interleavers and de-interleavers

This invention relates to interleavers. Interleavers are used, for example, in data transmission systems in which a number of different data signals are combined in a particular sequence into a single data channel. The present invention is particularly applicable to data which consists of a series of multibit data words, and which is to be transmitted over a transmission link which is subject to short term fading or distortion. An example of such a transmission link is a tropospheric scatter communication system, which suffers from Rayleigh fading. Although the use of data block codes can enable single errors or sometimes double errors to be corrected, the signal can nevertheless be seriously degraded since the whole of a codeword or a large portion of it may be distorted by a fade cycle. Under these circumstances no signal correction can be provided.

It is usual to provide some form of diversity transmission for a tropospheric scatter communication system to reduce the effect of Rayleigh fading. In a duel diversity system, signals are transmitted in two distinct forms which are subject to different fading characteristics so as to make it probable that at least one of the signal forms will be received at the far end of the transmission link in a sufficiently uncorrupted form as to permit the original signal to be obtained or reconstituted.

It is possible to use a block code in a tropospheric scatter communication without the need to resort to multiple diversities if interleaving is employed. Alternatively interleaving can be used to supplement multiple diversities. The principle of interleaving is to distribute the bits of any one code word over a long time period such that no two bits of the code word are separated by less than a certain time interval. This time interval is selected to minimise the probability that two or more bits of the same code word will be caught in a fade. An interleaver which is suitable for this purpose is described in GB—A—1 223 863. The use of shift registers having different lengths is known from DE—A—2240057; however, the data inputs are fed in parallel to all shift registors, a method which requires a relatively large total storage capacity. The present invention seeks to provide an interleaver which does not require the use of excessive data storage capacity.

According to this invention an interleaver includes an input for receiving a stream of data in the form of a sequence of code words, a plurality of data storage means each having a storage capacity which is a different integral multiple of a predetermined amount, means for routing data bits of the stream of data in turn into respective ones of the data storage means, and means for extracting data from the different storage means so that each data bit is stored therein for a period which is proportional to the storage capacity of the data storage means to which it is routed.

Preferably the number of data storage means is one less than the number of bits in each code word. Preferably again the storage capacity of the smallest data storage means is zero, i.e. it is constituted by a straight through path.

Each of the data storage means can be constituted by serial shift registers, each register having a length which corresponds to the required data storage capacity. Alternatively and preferably each data storage means is constituted by a random access memory, each data bit being held in a location of the memory until it is required to be read out. The plurality of data storage means is preferably formed of different locations of one or more random access memory devices. If the capacity of individual random access memory devices is not sufficient, a number of separate random access memory devices can be combined, but in general the division between the different data storage means will not be the same as the boundaries between different random access memories.

The invention is further described by way of example with reference to the accompanying drawings in which,

Figure 1 shows diagrammatically in simple form an interleaver and de-interleaver connected by a communication link,

Figure 2 illustrates in diagrammatic form the organisation of the data storage means and

Figure 3 is an explanatory table.

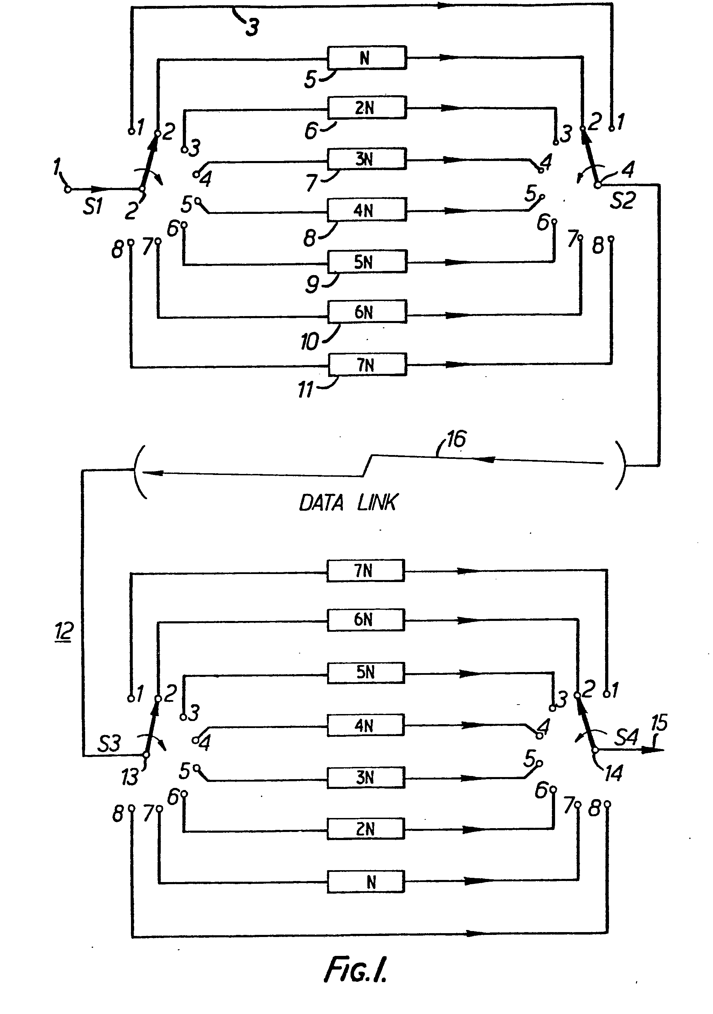

Referring to Figure 1, the interleaver illustrated is designed to operate with eight-bit code words. The interleaver comprises an input terminal 1 and a routing switch 2, which routes data bit by bit to a number of different data storage paths. Eight storage paths are illustrated with path 3 being merely a straight forward path between the switch 2 and a further output switch 4. The remaining paths comprise data stores 5 to 11 in the form of serial shift registers. Data store 5 has a capacity of N bits and the capacities of the remaining data stores are progressively increasing integral multiples of N up to 7 N bits. The two switches 2 and 4 are switched from position to position at the bit rate of the code words and the data in a shift register is clocked on by one bit only when that register is selected.

In describing the operation of the interleaver, it is assumed that N is 2, although as will be seen subsequently the value of N is likely to be very large in practice. In order to identify the individual bits in successive code words, the bits of a code word are labelled with the letters A through to H, with a subscript attached to each to identify the code word from which it came, e.g. '$C_5$' is the third bit of the fifth code word.

Assume that the interleaver has been working for some time, and that the first code word examined is identified by the subscript 1. Bits of previous code words will have lower numbered suffixes, and of later code words higher numbered ones. Thus the input data can be represented by the symbol sequence:

$$A_{-1}B_{-1}\ldots H_{-1}A_o\ldots H_oA_1B_1C_1\ldots H_1A_2B_2\ldots H_2A_3\ldots$$

The switches are arranged so that they are in position 1 (zero delay) synchronously with the 'A' bit in each code word. Examination of Figure 1 shows that the output symbol sequence present at switch 4 will be, starting with bit $A_1$:

$$A_1B_{-1}C_{-3}D_{-5}E_{-7}F_{-9}G_{-11}H_{-13}A_2B_0C_{-2}D_{-4}E_{-6}F_{-8}G_{-10}H_{-12}$$

since N=2. Thus the interleaving operation has preserved the "code word order" of the bits, but has distributed the bits in time so that no two bits of any input code word are separated by less than 16 bits in the output sequence. Here the interleaving time is thus equivalent to 16 bits.

The operation of the de-interleaver 12 follows from the previous explanation and is the converse of the interleaver operation. If the switches 13 and 14 are synchronised with switches 2 and 4, each bit will effectively be delayed by a fourteen-bit period and the output order at terminal 15 will be exactly the same as the input order at terminal 1.

It will be appreciated that two successive words of the interleaved output bit stream present on the data link 16 could be completely corrupted, but in the de-interleaved stream provided at terminal 15 only one error would result in each of the sixteen successive code words. Thus the effect of the interleaver is to convert error bursts into time dispersed errors. A suitably organised block code can correct errors of this kind.

The particular organisation of the interleaver illustrated in Figure 1 has the property of requiring the minimum possible amount of storage, since each bit is stored only until it has to be transmitted. However, it may not always be practicable to provide the storage capacity in the form of shift registers, since the lengths of the longer shift register would be very long indeed. In a tropospheric scatter communication system, the interleaver is typically required to provide an interleaving delay of approximately 24 milliseconds and to work at data bit rates of between 512 and 4224 thousand bits per second. With reference to Figure 1, it will be seen that one bit of storage in each shift register will result in eight bits delay in the output bit stream. Thus for 24 mSec interleaving delay at 512 kB/s, the storage required in the shortest shift register 5 is:

$$N = \frac{512 \times 10^3}{8} \times 24 \times 10^{-3} \text{ bits}$$

$$= 1536 \text{ bits.}$$

Thus the total storage needed is:

$$N (1+2+3+\ldots\ldots+7)$$

$$= \frac{N}{2} \cdot 7 \cdot 8$$

$$= 28N$$
$$= 43,008 \text{ bits.}$$

For the highest speed of 4224 kB/sec., the value of N is given by

$$N = \frac{4224 \times 10^3}{8} \times 24 \times 10^{-3}$$

$$= 12672 \text{ bits}$$

and the total storage for the seven shift registers needed is 354,816 bits.

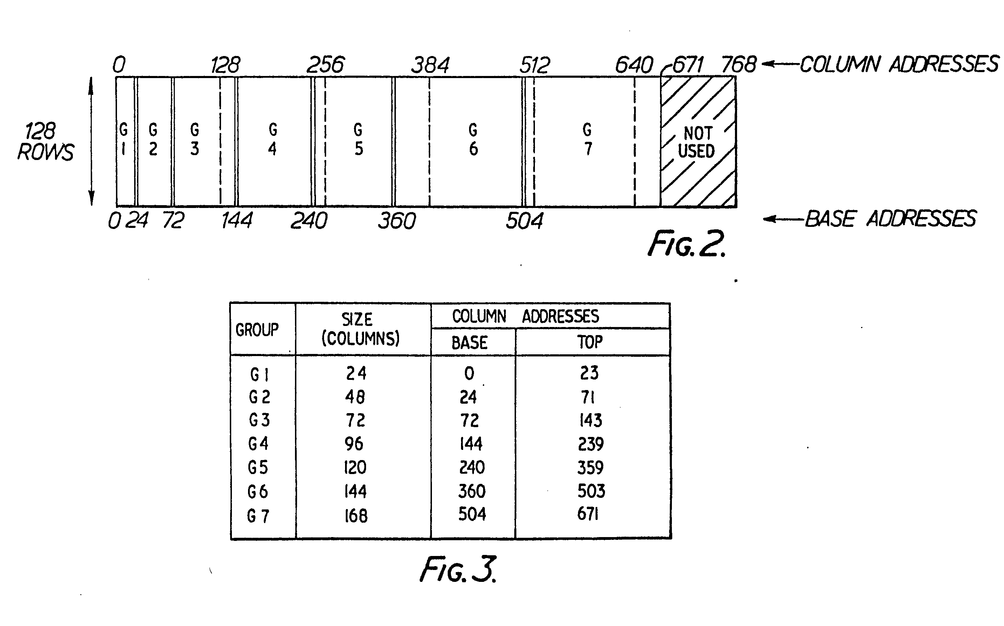

With such a large storage capacity requirement, the use of shift registers may not always be desirable. When the interleaver is required to operate over a wide range of different speeds, it may not be compatible with the available discrete lengths of shift registers which are readily obtainable. Secondly, the use of very long shift registers is not at present the most economical storage method. An alternative structure relating to the specific bit rate of 512 kB/sec and which does not require the use of serial shift registers is illustrated in Figure 2. The arrangement is functionally similar to that illustrated in Figure 1.

# 0 026 050

Referring to Figure 2, random access memories are used in which each is arranged as a 128 row by 128 column array. Memories having storage capacities of greater or less than this can be used as desired. The division of the total memory array into 128 column blocks is shown by dotted lines. In this large array any one of the total of 768 columns can be selected by a ten bit column address. The effective column addresses in the total array are indicated beside the 128 column divisions.

The memory array is now divided notionally into groups. Each group is associated with one of the required delays. The smallest group contains 24 columns and is denoted G1. The other groups, denoted G2 to G7, contain 24×2, 24×3, etc., columns. The groups are distinguished by their size (i.e. number of columns), and their base address (i.e. column address) in the 768 column memory array. The groups are indicated by the solid double-line divisions in Figure 2. The size and base addresses of the groups are given in the table shown in Figure 3.

Each of the groups G1 to G7 is treated in the same way as the shift registers in Figure 1 in that received data bits in a sequence of block codes are routed sequentially into the memory areas represented by these groups. The data bits are held in the memory for a time period which is proportional to the size of the group in which it is stored; they are then read out and combined in the required output sequence.

The construction and mode of operation of the de-interleaver may be identical to that of the interleaver, but with the switching sequence arranged so that the total time for which any given bit is stored in both the interleaver and the de-interleaver is a constant. It is necessary for the switching sequence in the de-interleaver to be synchronised with that of the interleaver for the original data words to be properly reconstituted. Unless correct synchronisation is obtained the error rate for the reconstituted data words will be extremely high, and in principle synchronisation can be achieved by stepping the switching sequence of the de-interleaver relative to that of the interleaver forwards or backwards by one bit period at a time until a minimum error rate results.

## Claims

1. An interleaver including an input for receiving a stream of data in the form of a sequence of code words, a plurality of data storage means each having a storage capacity which is a different integral multiple of a predetermined amount, means for routing data bits of the stream of data in turn into respective ones of the data storage means, and means for extracting data from the different storage means so that each data bit is stored therein for a period which is proportional to the storage capacity of the data storage means to which it is routed.

2. An interleaver as claimed in claim 1 and wherein the number of data storage means is one less than the number of bits in each code word.

3. An interleaver as claimed in claim 1 or 2 and wherein each of the data storage means is constituted by serial shift registers, each register having a length which corresponds to the required data storage capacity.

4. An interleaver as claimed in claim 1 or 2 and wherein each data storage means is constituted by a random access memory, each data bit being held in a location of the memory until it is required to be read out.

5. An interleaver as claimed in claim 4 and wherein the plurality of data storage means is formed of different locations of one or more random access memory devices.

6. A de-interleaver for receiving a stream of interleaved data bits produced by an interleaver as claimed in any of the preceding claims, the de-interleaver including a plurality of data storage means each having a storage capacity which is a different integral multiple of a predetermined amount, means for routing data bits of the stream of data in turn into respective ones of the data storage means, and means for extracting data from the different storage means so that each data bit is stored therein for a period which is proportional to the storage capacity of the data storage means to which it is routed so as to reconstitute the sequence of block codes received by the interleaver.

7. An interleaver as claimed in any of claims 1 to 5 and a de-interleaver as claimed in claim 6 arranged to co-operate via a tropospheric scatter communication link.

## Revendications

1. Un dispositif d'entrelacement comprenant une entrée pour recevoir un flux de données sous la forme d'une séquence de mots de code, plusieurs moyens de stockage de données disposant chacun d'une capacité de stockage qui est un multiple entier différent d'une quantité prédéterminée, des moyens pour acheminer tour à tour des bits de données du flux de données dans lesdits moyens de stockage ainsi que des moyens pour extraire les données des différents moyens de stockage pour que chaque bit de données y soit stocké pendant une période qui est proportionnelle à la capacité de stockage des moyens de stockage de données vers lesquels il est acheminé.

2. Un dispositif d'entrelacement comme décrit à la revendication n° 1 et où le nombre de moyens de stockage de données est inférieur d'une unité au nombre de bits de chaque mot de code.

3. Un dispositif d'entrelacement comme décrit aux revendications n° 1 ou n° 2 et où chacun des

4

moyens de stockage de données est composé de registres à décalage en série, chaque registre ayant une longueur qui correspond à la capacité requise de stockage de données.

4. Un dispositif d'entrelacement comme décrit aux revendications n° 1 ou n° 2 et où chaque moyen de stockage de données est composé d'une mémoire à accès aléatoire, chaque bit de données étant conservé en un emplacement de la mémoire jusqu'au moment où il doit être lu.

5. Un dispositif d'entrelacement comme décrit à la revendication n° 4 et où les divers moyens de stockage de données sont composés de différents emplacements d'une ou de plusieurs mémoires à accès aléatoire.

6. Un dispositif de désentrelacement pour recevoir un flux de bits de données entrelacées produit par un dispositif d'entrelacement comme décrit dans l'une des revendications décrites ci-avant, le dispositif de désentrelacement comprenant plusieurs moyens de stockage de données ayant chacun une capacité de stockage qui est un multiple entier différent d'une quantité prédéterminée, des moyens pour acheminer tour à tour les bits de données du flux de données dans les moyens de stockage de données correspondants ainsi que des moyens pour extraire les données des différents moyens de stockage pour que chaque bit de données y soit stocké pendant une période qui est proportionnelle à la capacité de stockage du moyen de stockage de données vers lequel il est acheminé afin de reconstituer la séquence de codes complets reçus par le dispositif de désentrelacement.

7. Un dispositif d'entrelacement comme décrit dans l'une des revendications n° 1 à n° 5 et un dispositif de désentrelacement comme décrit à la revendication n° 6 agencés de façon à coopérer avec une liaison de télécommunications par diffusion troposphérique.

**Patentansprüche**

1. Verschachtelungsvorrichtung mit einem Eingang einer als Datenstrom auftretenden Codewortfolge, mehrere Datenspeichereinrichtungen, jede mit einer Kapazität, welche ein unterschiedliches, ganzzahliges Vielfaches eines vorbestimmten Betrags ist. Einrichtungen zum Leiten der Datenbits des Datenstroms in entsprechende Einrichtungen der Datenspeicher-Einrichtungen sowie Einrichtungen zum Ausziehen von Daten aus den verschiedenen Speichereinrichtungen, so dass jedes Datenbit darin über eine Zeit gespeichert wird, die proportional zur Speicherkapazität jener Datenspeichereinrichtung ist, zu der es geleitet wird.

2. Verschachtelungseinrichtung nach Anspruch 1, dadurch gekennzeichnet, dass die Anzahl der Datenspeichereinrichtungen eine weniger als die Bitanzahl in jedem Codewort beträgt.

3. Verschachtelungseinrichtung nach Anspruch 1 oder 2, dadurch gekennzeichnet, dass jede der Datenspeichereinrichtungen aus Reihenschieberegistern besteht, wobei die Länge jedes Registers der geforderten Datenspeicherkapazität entspricht.

4. Verschachtelungsvorrichtung nach Anspruch 1 oder 2, dadurch gekennzeichnet, dass jede Datenspeichereinrichtung aus einem RAM besteht und jedes Datenbit bis zu seiner geforderten Auslesung in einem Speicherplatz gehalten wird.

5. Verschachtelungsvorrichtung nach Anspruch 4, dadurch gekennzeichnet, dass die Anzahl der Datenspeichereinrichtungen aus verschiedenen Speicherplätzen einer bzw. mehrerer RAM-Einrichtungen gebildet ist.

6. Entschachtelungsvorrichtung zum Empfang eines, von einer, einem beliebigen der vorhergehenden Ansprüche entsprechenden, von einer Verschachtelungsvorrichtung gebildeten verschachtelten Datenbitstroms, wobei die Entschachtelungsvorrichtung mehrere Datenspeichereinrichtungen enthält, von denen jede eine Speicherkapazität hat, die ein unterschiedliches ganzzahliges Vielfaches eines vorbestimmten Betrages ist, Einrichtungen zum Leiten von Datenbits des Datenstroms in entsprechende Datenbits der Datenspeichereinrichtungen sowie Einrichtungen zum Ausziehen von Daten aus den verschiedenen Speichereinrichtungen, so dass jedes Datenbit über eine Zeit gespeichert wird, die proportional zur Speicherkapazität zu jener Datenspeichereinrichtung ist, zu der es geleitet wird, um die von der Verschachtelungsvorrichtung empfangene Blockcodefolge wieder herzustellen.

7. Verschachtelungsvorrichtung nach einem der Ansprüche 1 bis 5 und Entschachtelungsvorrichtung nach Anspruch 6, dadurch gekennzeichnet, dass sie über eine troposphärische Streustrahlungs-Nachrichtenstrecke zusammenarbeiten.

DATA LINK

Fig.I.

*FIG.2.*

← COLUMN ADDRESSES

← BASE ADDRESSES

| GROUP | SIZE (COLUMNS) | COLUMN ADDRESSES | |
|---|---|---|---|
| | | BASE | TOP |
| G 1 | 24 | 0 | 23 |
| G 2 | 48 | 24 | 71 |
| G 3 | 72 | 72 | 143 |
| G 4 | 96 | 144 | 239 |
| G 5 | 120 | 240 | 359 |
| G 6 | 144 | 360 | 503 |
| G 7 | 168 | 504 | 671 |

*FIG. 3.*